# EUROPÄISCHE PATENTANMELDUNG

(11) **EP 3 731 151 A1**
(43) Veröffentlichungstag der Anmeldung: **28.10.2020**
(21) Anmeldenummer: 19170588.8
(22) Anmeldetag: 23.04.2019
(51) Int. Cl.: G06N 3/04, G06N 7/00, G06N 3/08, G06F 17/50

(54) **VERFAHREN UND VORRICHTUNG ZUM GENERIEREN EINES COMPUTERLESBAREN MODELLS FÜR EIN TECHNISCHES SYSTEM**

(71) Anmelder: Siemens Aktiengesellschaft, 80333 München (DE)
(72) Erfinder: Botero Halblaub, Andrés, 85614 Kirchseeon (DE); Fischer, Jan, 81541 München (DE); Garhammer, Andreas, 84367 Reut (DE); Zhou, Yayun, 81739 München (DE); Liu, Siyuan, 81369 München (DE); Wehrstedt, Jan Christoph, 81829 München (DE)

(57) **Zusammenfassung**

Die Erfindung betrifft ein computerimplementiertes Verfahren zum Generieren eines computerlesbaren Modells (M) für ein technisches System auf Basis von textbasierten Spezifikationsdaten (D_spec) für das technische System, wobei die textbasierten Spezifikationsdaten mindestens eine Systembedingung spezifizieren. Es wird eine Vielzahl von Modellkomponenten (MK) zum computergestützten Modellieren des technischen Systems bereitgestellt, wobei einer jeweiligen Modellkomponente (MK) eine Modellkomponentenkennung (MKK) zugeordnet ist. Mittels Generative Adversarial Networks wird auf Basis der textbasierten Spezifikationsdaten (D_spec) Modellkomponenten (MKK) anhand deren Modellkomponentenkennungen (MKK) aus der Vielzahl Modellkomponenten selektiert und aus den selektierten Modellkomponenten ein computerlesbares Modell (M) für das technische System derart generiert, dass Modelldaten (MD) des computerlesbaren Modells mindestens eine in den textbasierten Spezifikationsdaten spezifizierte Systembedingung erfüllen.

## Beschreibung

Die Erfindung betrifft ein computerimplementiertes Verfahren und eine Vorrichtung zum Generieren eines computerlesbaren Modells für ein technisches System mittels eines künstlichen neuronalen Netzes, insbesondere mittels Generative Adversarial Neural Networks. Ferner ist die Erfindung auf ein Computerprogrammprodukt zum Ausführen der Schritte eines erfindungsgemäßen Verfahrens gerichtet.

Computergestützte Simulationen können als digitales Planungsinstrument von technischen Systemen, z.B. Anlagen oder Fabrikanlagen, genutzt werden. Mittels Simulationen können beispielsweise Planungsentwürfe validiert werden. Des Weiteren können Computersimulationen während der Betriebsphase einer Anlage eingesetzt werden, um beispielsweise betriebsgleitende Assistenzsysteme zu realisieren. Für beide Arten von Simulationen sind Simulationswerkzeuge oder Simulationstools bekannt, mit denen Simulationsmodelle aus bestehenden Simulationskomponenten-Bibliotheken manuell von einem Simulationsexperten erstellt werden können. Die Erstellung eines Simulationsmodells auf Basis eines verfügbaren Fabrikplans und verfügbarer Fabrikdaten erfordert in der Regel ein hohes Maß an Fachwissen vom Simulationsexperten, da dieser zunächst geeignete Simulationskomponenten zum Abbilden der realen Fabrickomponenten bestimmen und/oder erstellen muss. Daher kann die Erstellung eines Simulationsmodells zeitaufwändig, fehleranfällig und/oder qualitativ unterschiedlich sein.

Es sind weiter sogenannte erzeugende gegnerische Neuronale Netzwerke, englisch "Generative Adversarial Networks", kurz GAN, bekannt, die zu den Algorithmen zum unüberwachten Lernen gehören. Generative Adversarial Networks umfassen zwei künstliche neuronale Netze, die derart trainiert werden, dass eines der neuronalen Netze Kandidaten erstellt (der Generator), das zweite neuronale Netzwerk bewertet diese Kandidaten (der Diskriminator). Generative Adversarial Networks können beispielsweise für die Bildgenerierung photorealistischer Bilder, Videos oder Sequenzen genutzt werden.

Es ist eine Aufgabe der vorliegenden Erfindung, die Erstellung eines computergestützten Modells für ein technisches System, wie z.B. für eine Fabrikanlage, zu erleichtern.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt.

Gemäß einem ersten Aspekt betrifft die Erfindung ein computerimplementiertes Verfahren zum Generieren eines computerlesbaren Modells für ein technisches System, umfassend die Verfahrensschritte:
- Erfassen von textbasierten Spezifikationsdaten für das technische System, wobei die textbasierten Spezifikationsdaten mindestens eine Systembedingung spezifizieren,
- Bereitstellen einer Vielzahl von Modellkomponenten zum computergestützten Modellieren des technischen Systems, wobei einer jeweiligen Modellkomponente eine Modellkomponentenkennung zugeordnet ist,
- Bereitstellen eines ersten neuronalen Netzes, das mittels eines zweiten neuronalen Netzes darauf trainiert ist, auf Basis textbasierter Spezifikationsdaten für ein technisches System Modellkomponenten anhand deren Modellkomponentenkennungen aus einer Vielzahl von Modellkomponenten zu selektieren und aus den selektierten Modellkomponenten ein computerlesbares Modell für das technische System derart zu generieren, dass Modelldaten des computerlesbaren Modells mindestens eine in den textbasierten Spezifikationsdaten spezifizierte Systembedingung erfüllen,
- Generieren eines computerlesbaren Modells für das technische System aus der bereitgestellten Vielzahl von Modellkomponenten in Abhängigkeit der erfassten textbasierten Spezifikationsdaten mittels des ersten neuronalen Netzes.

Sofern es in der nachfolgenden Beschreibung nicht anders angegeben ist, beziehen sich die Begriffe "durchführen", "berechnen", "bereitstellen", "rechnergestützt", "rechnen", "feststellen", "generieren", "konfigurieren", "rekonstruieren", "extrahieren" und dergleichen, vorzugsweise auf Handlungen und/oder Prozesse und/oder Verarbeitungsschritte, die durch einen Computer durchgeführt werden und die Daten verändern und/oder erzeugen und/oder die Daten in andere Daten überführen, wobei die Daten insbesondere als physikalische Größen dargestellt werden oder vorliegen können, beispielsweise als elektrische Impulse. Insbesondere sollte der Ausdruck "Computer" möglichst breit ausgelegt werden, um insbesondere alle elektronischen Geräte mit Datenverarbeitungseigenschaften abzudecken. Computer können somit beispielsweise Personal Computer, Server, Handheld-Computer-Systeme, Pocket-PC-Geräte, Mobilfunkgeräte und andere Kommunikationsgeräte, die rechnergestützt Daten verarbeiten können, Prozessoren und andere elektronische Geräte zur Datenverarbeitung sein.

Unter "computergestützt" oder "computerimplementiert" kann im Zusammenhang mit der Erfindung beispielsweise eine Implementierung des Verfahrens verstanden werden, bei dem insbesondere ein Prozessor mindestens einen Verfahrensschritt des Verfahrens ausführt. Unter "computerlesbar" kann im Zusammenhang mit der Erfindung beispielsweise ein Datensatz verstanden werden, der so beschaffen ist, dass er von einem Computer lesbar und/oder interpretierbar ist. Des Weiteren kann insbesondere ein "computerlesbares Modell" Daten umfassen, die von einem Computer lesbar und verarbeitbar sind. Ein computerlesbares Modell kann beispielsweise ein formales Modell oder ein computergestütztes Simulationsmodell sein.

Die Erfindung ermöglicht die Erstellung eines computerlesbaren Modells für ein technisches System, das derart eingerichtet ist, computergestützt das reale technische System abzubilden und/oder zu simulieren. Eine computergestützte Simulation bzw. Computersimulation dient beispielsweise dazu, physikalische Prozesse des technischen Systems abzubilden und zu analysieren.

Ein technisches System kann beispielsweise eine Anlage oder eine Fabrikanlage oder eine Maschine, wie z.B. ein Generator oder ein Motor, oder eine Werkzeugmaschine, etc., sein. Ein technisches System umfasst eine Vielzahl von Komponenten. Komponenten des realen technischen Systems können Hardware- und/oder Software-Komponenten sein. Modellkomponenten sind entsprechend Abbildungen der realen Komponenten. Modellkomponenten können insbesondere als Simulationskomponenten bezeichnet werden, die vorzugsweise derart gestaltet sind, dass damit physikalische und/oder funktionale Prozesse und/oder Eigenschaften der realen Komponente computergestützt abgebildet werden können.

Es ist ein Vorteil der vorliegenden Erfindung, aus einer Vielzahl von Modellkomponenten, beispielsweise aus einer Modellkomponentenbibliothek, mittels eines ersten trainierten künstlichen neuronalen Netzes, insbesondere einem generativen neuronalen Netz, automatisch ein computerlesbares Modell für ein technisches System zu erzeugen, welches den eingegebenen textbasierten Spezifikationsdaten genügt. Anhand einer eingelesenen textbasierten Spezifikation des technischen Systems kann somit ein Modell für das technische System generiert werden. Es wird folglich aus den Modelkomponenten ein Modell mit einer Topologie erzeugt, die der Topologie des entsprechenden realen technischen Systems entspricht.

Außerdem ermöglicht das Verfahren, eine Reduktion des manuellen Aufwandes beim Erstellen eines computerlesbaren Modells für ein technisches System, da die Modellgenerierung und Modellparametrierung automatisch durchgeführt werden kann. Dies ermöglicht insbesondere eine gleichbleibende Qualität der Modelle. Dieser datenbasierte Ansatz ist darüber hinaus robuster und flexibler als beispielsweise ein regelbasierter Ansatz, bei dem Modelle anhand festgelegter Regeln erzeugt werden.

Die Modellkomponenten werden anhand spezifischer Modellkomponentenkennungen selektiert und zu dem computerlesbaren Modell zusammengefügt. Das generierte computerlesbare Modell kann beispielsweise zur Simulation und/oder Steuerung und/oder Analyse des technischen Systems genutzt werden. Insbesondere kann das erfindungsgemäße Verfahren dazu genutzt werden, ein technisches System zu planen, d.h. zunächst ein computerlesbares Modell zu erstellen bevor das reale technische System konstruiert wird.

Die Modellgenerierung erfolgt auf Basis der erfassten textbasierten Spezifikationsdaten. Textbasierte Spezifikationsdaten können beispielsweise in Form einer textuellen Anforderung vorliegen, die ein technisches System erfüllen soll, wie z.B. ein Produktionsziel einer Anlage. Textbasierte Spezifikationsdaten können beispielsweise lediglich Randbedingungen und/oder Grundvoraussetzungen an das technische System umfassen. Diese können später mit den Modelldaten des generierten Modells abgeglichen werden.

In einer vorteilhaften Ausführungsform des computerimplementierten Verfahrens kann anhand der textbasierten Spezifikationsdaten für das technische System Parameterwerte für Parameter des technischen Systems und/oder von Komponenten des technischen Systems extrahiert und das generierte computerlesbare Modell in Abhängigkeit der extrahierten Parameterwerte und mittels des ersten neuronalen Netzes parametrisiert werden.

Die textbasierten Spezifikationsdaten können beispielsweise Parameterwerte umfassen, welche bei der Generierung des computerlesbaren Modells berücksichtigt werden können. Dazu können beispielsweise mittels einer Methode zur Verarbeitung von Textdaten und/oder natürlicher Sprache aus den textbasierten Spezifikationsdaten Informationen gewonnen werden, aus denen sich Parameterwerte ableiten lassen.

In einer vorteilhaften Ausführungsform des computerimplementierten Verfahrens kann das erste neuronale Netz mittels eines zweiten neuronalen Netzes und anhand von Trainingsdaten trainiert werden,
- wobei die Trainingsdaten mindestens textbasierte Spezifikationsdaten eines technischen Systems und/oder Modelldaten von mindestens einem computerlesbaren Modell eines technischen Systems umfassen können,
- wobei das Training des ersten neuronalen Netzes mittels des zweiten neuronalen Netzes umfasst, dass mittels des ersten neuronalen Netzes auf Basis textbasierter Spezifikationsdaten für ein technisches System Modellkomponenten anhand deren Modellkomponentenkennungen aus einer Vielzahl von Modellkomponenten selektiert werden, aus den selektierten Modellkomponenten ein computerlesbares Modell für das technische System generiert wird und mittels des zweiten neuronalen Netzes anhand der Trainingsdaten geprüft wird, ob die Modelldaten des vom ersten neuronalen Netz generierten computergestützten Modells die in den textbasierten Spezifikationsdaten spezifizierte Systembedingung erfüllen.

Das erste neuronale Netz kann auch als Generator-Netz bezeichnet werden. Das zweite neuronale Netz kann auch als Diskriminator-Netz bezeichnet werden. Zusammen beschreiben sie ein Generative Adversarial Network. Beide neuronale Netze werden insbesondere gemeinsam trainiert. Trainingsdaten umfassen beispielsweise Daten zu einer Vielzahl von technischen Systemen, wobei für jedes technische System sowohl Modelldaten computerlesbarer Modelle als auch zugeordnete textbasierte Spezifikationsdaten gegeben sind. Für die Generierung eines computerlesbaren Modells auf Basis von textbasierten Spezifikationsdaten für ein technisches System wird das Generator-Netz mittels des Diskriminator-Netzes trainiert. Die Generierung des Modells erfolgt aus einer Vielzahl von Modellkomponenten und anhand deren Modellkomponentenkennungen. Vorzugsweise werden Modellkomponenten selektiert, deren Modellkomponentenkennungen den textbasierten Spezifikationsdaten zugeordnet werden können. Das generierte computerlesbare Modell wird anhand von weiteren (Trainings-)Modelldaten, die den textbasierten Spezifikationsdaten zugeordnet sind, vom zweiten neuronalen Netz geprüft, ob das generierte Modell die in den textbasierten Spezifikationsdaten spezifizierte Systembedingung erfüllt. Das trainierte Generator-Netz wird anschließend zum Generieren eines computerlesbaren Modells für ein technisches System bereitgestellt, wie z.B. gespeichert.

In einer vorteilhaften Ausführungsform des computerimplementierten Verfahrens kann ein bereitgestelltes computergestütztes Modell für das technische System mittels des zweiten neuronalen Netzes validiert werden.

Das Diskriminator-Netz kann des Weiteren nach dem Training des Generative Adversarial Network insbesondere dazu genutzt werden, ein bereitgestelltes computerlesbares Modell zu validieren. Dazu werden vom trainierten zweiten neuronalen Netz die Modelldaten des computerlesbaren Modells geprüft und ein Prüfergebnis ausgegeben. Es kann damit insbesondere geprüft werden, ob die Topologie des computerlesbaren Modells und/oder eine Ausgabe einer Simulation auf Basis des computerlesbaren Modells im Vergleich zu den spezifizierten Systembedingungen sinnig ist.

In einer vorteilhaften Ausführungsform des computerimplementierten Verfahrens können Spezifikationsdaten des technischen Systems mittels einer Spracheingabeeinheit erfasst, mittels einer Auswerteeinheit in textbasierte Spezifikationsdaten umgewandelt und die textbasierten Spezifikationsdaten bereitgestellt werden.

Beispielsweise können Spezifikationsdaten von einem Nutzer mündlich übermittelt werden, mittels einer Spracheingabeeinheit erfasst und zur weiteren Verwendung in textbasierte Spezifikationsdaten umgewandelt werden.

In einer vorteilhaften Ausführungsform des computerimplementierten Verfahrens kann das computerlesbare Modell als ein computergestütztes Simulationsmodell zum Simulieren des technischen Systems generiert werden.

Die Erstellung eines computergestützten Simulationsmodells aus dem computerlesbaren Modell kann vorzugsweise mittels eines Simulationswerkzeugs - auch als Simulationstool bezeichnet - in einer Simulationseinheit, die mindestens einen Prozessor umfasst, durchgeführt werden. Dabei ist die Eingabe der Simulationseinheit vorzugsweise die Ausgabe des generativen neuronalen Netzes. Das computergestützte Simulationsmodell kann aus bereitgestellten Simulationskomponenten erstellt werden. Simulationskomponenten sind beispielsweise computergestützte Abbildungen der realen Komponenten, die vorzugsweise derart gestaltet sind, dass damit physikalische und/oder funktionale Prozesse und/oder Eigenschaften der realen Komponente computergestützt simuliert werden können. Ein computergestütztes Simulationsmodell ist insbesondere ein ausführbares Modell, mit welchem beispielsweise ein zeitlicher Verlauf eines Prozesses eines technischen Systems computergestützt simuliert werden kann.

In einer vorteilhaften Ausführungsform des computerimplementierten Verfahrens kann das technische System und/oder ein Prozess oder eine Funktionalität des technischen Systems mittels des computergestützten Simulationsmodells computergestützt simuliert und/oder das computergestützte Simulationsmodell zum Steuern des technischen Systems ausgegeben werden.

Nach der Generierung und Parametrisierung des computergestützten Simulationsmodells kann das Simulationsmodell bereitgestellt und computergestützt in einer Simulationsumgebung ausgeführt werden. Insbesondere können anschließend die entsprechenden Simulationsdaten zum Steuern des realen technischen Systems ausgegeben werden. Mittels der computergestützten Simulation kann beispielsweise eine Validierung eines Prozesses und/oder einer Funktionalität und/oder einer Spezifikation des technischen Systems durchgeführt werden.

Gemäß einem zweiten Aspekt betrifft die Erfindung eine Vorrichtung zum Generieren eines computerlesbaren Modells für ein technisches System, wobei die Vorrichtung mindestens einen Prozessor zum Durchführen der Schritte eines Verfahrens nach den vorhergehenden Ansprüchen aufweist.

Bei einem Prozessor kann es sich insbesondere um einen Hauptprozessor (engl. Central Processing Unit, CPU), einen Mikroprozessor oder einen Mikrokontroller, beispielsweise eine anwendungsspezifische integrierte Schaltung oder einen digitalen Signalprozessor, möglicherweise in Kombination mit einer Speichereinheit zum Speichern von Programmbefehlen, etc. handeln. Bei einem Prozessor kann es sich beispielsweise auch um einen IC (integrierter Schaltkreis, engl. Integrated Circuit) oder einen Grafikprozessor GPU (Graphics Processing Unit/Tensor Processing Unit TPU) oder einem Field Programmable Gate Array (FPGA) handeln. Der Prozessor kann eine oder mehrere Rechenkerne (multi-core) aufweisen. Auch kann unter einem Prozessor ein virtualisierter Prozessor oder eine Soft-CPU verstanden werden. Es kann sich beispielsweise auch um einen programmierbaren Prozessor handeln, der mit Konfigurationsschritten zur Ausführung des genannten erfindungsgemäßen Verfahrens ausgerüstet wird oder mit Konfigurationsschritten derart konfiguriert ist, dass der programmierbare Prozessor die erfindungsgemäßen Merkmale des Verfahrens oder anderer Aspekte und Teilaspekte der Erfindung implementiert.

Die Vorrichtung kann beispielsweise mit einer Simulationseinheit bzw. einem Simulationswerkzeug gekoppelt sein, so dass ein computergestütztes Simulationsmodell zum Simulieren des technischen Systems generiert und/oder ausgeführt werden kann.

Des Weiteren betrifft die Erfindung ein Computerprogrammprodukt, das direkt in einen programmierbaren Computer ladbar ist, umfassend Programmcodeteile, die dazu geeignet sind, die Schritte eines erfindungsgemäßen computerimplementierten Verfahrens durchzuführen.

Ein Computerprogrammprodukt, wie zum Beispiel ein Computerprogramm-Mittel, kann beispielsweise als Speichermedium oder Datenträger, wie zum Beispiel als Speicherkarte, USB-Stick, CD-ROM, DVD oder auch in Form einer herunterladbaren Datei von einem Server in einem Netzwerk bereitgestellt oder geliefert werden.

Ausführungsbeispiele des erfindungsgemäßen computerimplementierten Verfahrens und der Vorrichtung sind in den Zeichnungen beispielhaft dargestellt und werden anhand der nachfolgenden Beschreibung näher erläutert. Es zeigen:
- Fig. 1:: ein Ablaufdiagramm eines Ausführungsbeispiels eines erfindungsgemäßen Verfahrens;
- Fig. 2:: eine schematische Darstellung eines weiteren Ausführungsbeispiels eines erfindungsgemäßen Verfahrens;
- Fig. 3:: eine schematische Darstellung eines weiteren Ausführungsbeispiels eines erfindungsgemäßen Verfahrens; und
- Fig. 4:: eine schematische Darstellung einer erfindungsgemäßen Vorrichtung in Blockdarstellung.

Einander entsprechende Teile sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

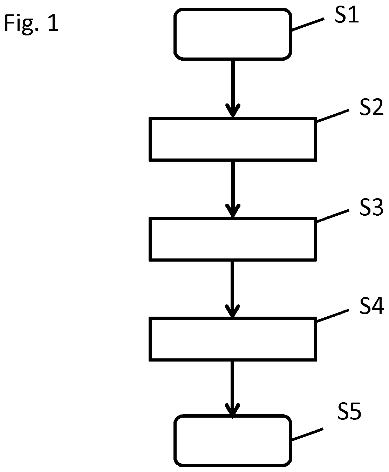

Figur 1 zeigt ein Ablaufdiagramm eines erfindungsgemäßen Verfahrens zum Generieren eines computerlesbaren Modells für ein technisches System, wie z.B. eine Fabrikanlage. Beispielsweise kann das Verfahren dazu genutzt werden, eine noch nicht bestehende Anlage am Computer zu planen.

Im Schritt S1 wir eine textbasierte Spezifikation für die zu modellierende Anlage bereitgestellt und als textbasierte Spezifikationsdaten erfasst. Diese können beispielsweise Anforderungen, Randbedingungen, Konstruktionsbedingungen, Betriebsbedingungen, ein Produktionsziel, oder ähnliches für die Fabrikanlage umfassen. Die textbasierten Spezifikationsdaten können beispielsweise von einem Nutzer bereitgestellt, d.h. z.B. formuliert und/oder eingegeben, und können für die weiteren Schritte eingelesen werden. Alternativ können die textbasierten Spezifikationsdaten aus einer Datei extrahiert und/oder eingelesen werden. Es soll nun mittels des computerimplementierten Verfahrens ein computerlesbares Modell erstellt werden, welches die in den textbasierten Spezifikationsdaten spezifizierten Systembedingungen für die Fabrikanlage erfüllen. Beispielsweise soll ein computerlesbares Modell einer Anlage generiert werden, welches ein vorgegebenes Produktionsziel für die Anlage erfüllt. In anderen Worten, es soll mittels des erfindungsgemäßen Verfahrens eine Anlage aus Komponenten geplant werden und dafür ein Modell aus entsprechenden Modellkomponenten generiert werden, so dass die modellierte Anlage das vorgegebene Produktionsziel erfüllt.

Ein computerlesbares Modell kann beispielsweise ein formalisiertes Engineering-Modell sein, das als computerlesbare Textdaten, z.B. in einer XML-Datei gespeichert, ausgegeben werden soll. Alternativ kann ein computerlesbares Modell auch ein Computersimulationsmodell sein, welches von einem Computer gelesen und ausgeführt werden kann. Außerdem kann ein computerlesbares Modell als abstrakte Anlagenarchitektur, z.B. als SysML- oder AutomationML-Datei, ausgegeben werden.

Im Schritt S2 wird dazu eine Vielzahl von Modellkomponenten bereitgestellt. Beispielsweise wird eine Bibliothek oder Datenbank mit Modellkomponenten zum computergestützten Modellieren von technischen Systemen angesteuert. Modellkomponenten sind vorzugsweise jeweils realen Komponenten, wie z.B. Software und/oder Hardware, eines realen technischen Systems zugeordnet, so dass mittels einer Modellkomponente eine reale Komponente abgebildet bzw. modelliert und/oder simuliert werden kann.

Die Zuordnung einer Modellkomponente zu einer realen Komponente kann beispielsweise vorab mittels einer trainierten maschinellen Lernmethode erfolgen, wobei die maschinelle Lernmethode darauf trainiert ist, realen Komponenten eines technischen Systems jeweils eine Modellkomponente zuzuordnen, die die Funktionalität und/oder Physik der realen Komponente abbildet.

Eine jeweilige Modellkomponente ist durch eine Modellkomponentenkennung gekennzeichnet. Eine Modellkomponentenkennung kann in Form von Kennungsdaten vorliegen, welche beispielsweise eine Bezeichnung, Kennzeichnung, ein Name, ein Label, eine Identifikationsnummer, Beschreibung, Kurzbeschreibung oder ähnliches umfassen können. Modellkomponentenkennungen sind vorzugsweise eindeutig einer Modellkomponente zugeordnet. Anhand von Kennungsdaten können die jeweiligen Modellkomponenten und/oder deren Funktion beschrieben und/oder identifiziert werden. So kann beispielsweise auf Basis der textbasierten Spezifikationsdaten eine Selektion von passenden Modellkomponenten anhand deren Modellkomponentenkennungen erfolgen.

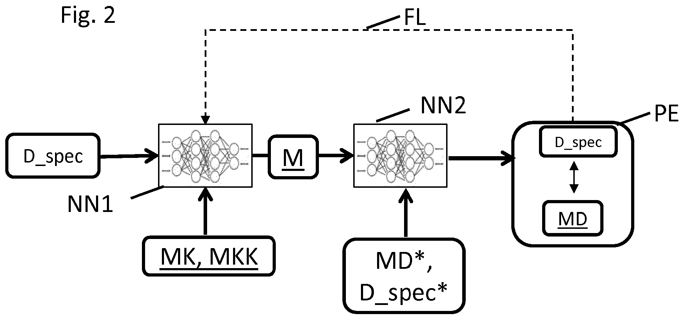

Im Schritt S3 wird ein trainiertes generatives neuronales Netz bereitgestellt. Das trainierte generative neuronale Netz wird beispielsweise als Datenstruktur bereitgestellt, wie z.B. auf einer Speichereinheit gespeichert und von dort eingelesen. Vorzugsweise wird das generative neuronale Netz zunächst mittels eines Diskriminator-Netzes trainiert, wie beispielhaft in Figur 2 gezeigt. Das generative neuronale Netz ist derart trainiert, dass es auf Basis von eingelesenen textbasierten Spezifikationsdaten für ein technisches System aus einer Modellkomponenten-Datenbank anhand von jeweiligen Modellkomponentenkennungen bestimmte Modellkomponenten selektiert und aus den selektierten Modellkomponenten ein computerlesbares Modell generiert. Dabei wird das generierte computerlesbare Modell derart erstellt, dass die Modelldaten mindestens eine in eingelesenen textbasierten Spezifikationsdaten spezifizierte Systembedingung erfüllen. Die Modelldaten eines generierten Modells werden beispielsweise mit den Spezifikationsdaten abgeglichen.

Alternativ kann auch eine Systemsimulation mittels des generierten Modells durchgeführt werden, um zu testen, ob das Modell die spezifizierten Systembedingungen erfüllt. Beispielsweise kann die Produktion eines Produkts mittels des generierten Modells simuliert werden, um zu testen, ob ein Produktionsziel einer Anlage erfüllt ist.

Im Schritt S4 werden die erfassten textbasierten Spezifikationsdaten übermittelt und in das trainierte generative neuronale Netz eingelesen. Auf Basis der eingelesenen textbasierten Spezifikationsdaten generiert das generative neuronale Netz ein computerlesbares Modell aus Modellkomponenten einer Modellkomponenten-Datenbank.

Im Schritt S5 wird das generierte computerlesbare Modell ausgegeben. Beispielsweise wird das generierte computerlesbare Modell als Datenstruktur ausgegeben. Das computerlesbare Modell kann beispielsweise für die Planung, Konstruktion, zum computergestützten Simulieren und/oder zum Steuern der Fabrikanlage genutzt werden. So kann beispielsweise eine Fabrikanlage mittels des ausgegebenen computerlesbaren Modells geplant und/oder konstruiert und/oder gesteuert werden.

Figur 2 zeigt ein Ausführungsbeispiel eines erfindungsgemäßen Verfahrens zum Trainieren eines Generative Adversarial Network, das zum Generieren eines computerlesbaren Modells für ein technisches System geeignet ist. Es sind insbesondere die Trainingsschritte des Trainings des ersten neuronalen Netzes NN1 und zweiten neuronalen Netzes NN2 gezeigt.

Unter einem Training eines neuronalen Netzes sei allgemein eine Optimierung einer Abbildung von Eingangsparametern auf einen oder mehrere Zielparameter verstanden. Diese Abbildung wird nach vorgegebenen, gelernten und/oder zu lernenden Kriterien während einer Trainingsphase optimiert. Eine Trainingsstruktur kann zum Beispiel eine Vernetzungsstruktur von Neuronen eines neuronalen Netzes und/oder Gewichte von Verbindungen zwischen den Neuronen umfassen, die durch das Training so ausgebildet werden, dass die vorgegebenen Kriterien möglichst gut erfüllt werden.

Das erste neuronale Netz NN1 generiert auf Basis textbasierter Spezifikationsdaten D_spec für ein technisches System ein computerlesbares Modell M. Dazu werden die textbasierten Spezifikationsdaten D_spec in das erste neuronale Netz NN1 eingelesen. Außerdem werden dem ersten neuronalen Netz NN1 eine Vielzahl von Modelkomponenten MK, denen jeweils Modellkomponentenkennungen MKK zugeordnet sind, bereitgestellt. Beispielsweise wird das erste neuronale Netz NN1 mit einer Datenbank oder Bibliothek, in der Modellkomponenten MK gespeichert sind, gekoppelt. Daraus selektiert das erste neuronale Netz NN1 auf Basis der eingelesenen textbasierten Spezifikationsdaten D_spec und anhand der Modellkomponentenkennungen MKK bestimmte Modellkomponenten MK für das computerlesbare Modell M.

Beispielsweise umfassen die Spezifikationsdaten D_spec die Anforderung "Anlage zur Produktion von Produkt X in Zeit Y", wobei "X" und "Y" einen bestimmten Wert aufweisen. Anhand diesen Spezifikationsdaten D_spec können passende Modelkomponenten selektiert werden, wie z.B. Modellkomponenten für Werkzeugmaschinen, Förderbänder, etc.. Aus den selektierten Modellkomponenten MK wird ein computerlesbares Modell generiert.

Das generierte computerlesbare Modell M wird an das zweite neuronale Netz NN2 ausgegeben und dort eingelesen. Das zweite neuronale Netz NN2 prüft das computerlesbare Modell M anhand von Trainingsdaten. Beispielsweise wird derart geprüft, ob das generierte computerlesbare Modell M sinnig ist. Dazu werden dem zweiten neuronalen Netz NN2 Modelldaten MD* und zugehörige textbasierte Spezifikationsdaten D_spec* von einer Vielzahl von technischen Systemen als Trainingsdaten bereitgestellt. In anderen Worten, die Trainingsdaten umfassen mindestens ein Paar von zueinander zugeordneten Modelldaten MD* und textbasierten Spezifikationsdaten D_spec*. Die textbasierten Spezifikationsdaten D_spec* der Trainingsdaten sind dabei vorzugsweise gleich oder ähnlich zu den ursprünglich eingelesenen textbasierten Spezifikationsdaten D_spec. Beispielsweise sind die Trainingsdaten MD*, D_spec* von anderen technischen Systemen und/oder ähnlichen technischen Systemen wie das zu modellierende technische System, die die gleichen oder ähnlichen Systembedingungen aufweisen.

Anhand der Trainingsdaten MD*, D_spec* kann das zweite neuronale Netz NN2 prüfen, ob das vom ersten neuronalen Netz NN1 generierte computerlesbare Modell M die in den textbasierten Spezifikationsdaten D_spec spezifizierte Systembedingung erfüllt. Dazu werden die Modelldaten MD des computerlesbaren Modells M mit den Trainingsdaten MD*, D_spec* verglichen. Beispielsweise kann dabei geprüft werden, ob die Modelldaten MD einer statistischen Verteilung der Trainings-Modelldaten MD* folgen.

Abhängig vom Prüfergebnis PE kann eine erneute Generierung eines computerlesbaren Modells M angestoßen werden, FL, wenn beispielsweise die Modelldaten MD die spezifizierte Systembedingung D_spec nicht erfüllt. Das Training erfolgt vorzugsweise, bis ein computerlesbares Modell erzeugt wird, dass vom zweiten neuronalen Netz NN2 als sinnig bzw. passend geprüft wird, d.h. dessen Modelldaten die spezifizierte Systembedingung zumindest innerhalb eines vorgegebenen Toleranzbereiches erfüllen. Nach dem Training können das erste und das zweite neuronale Netz NN1, NN2 beispielsweise als Datenstruktur ausgegeben und bereitgestellt werden.

Mittels des trainierten zweiten neuronalen Netzes NN2 kann beispielsweise ein vorgegebenes computerlesbares Modell eines technischen Systems validiert werden, d.h. es kann geprüft werden, ob das Modell derart gestaltet ist, dass es eine Systembedingung erfüllt.

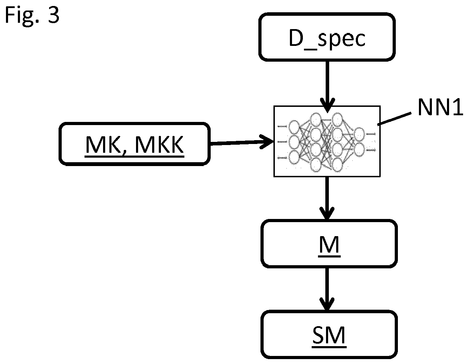

Figur 3 zeigt ein weiteres Ausführungsbeispiel des erfindungsgemäßen Verfahrens. Es ist ein trainiertes erstes neuronales Netz NN1 gezeigt, welches als generatives neuronales Netz ausgestaltet ist. Das Training des ersten neuronalen Netzes NN1 kann beispielsweise wie anhand Figur 2 gezeigt durchgeführt werden. Das erste neuronale Netz NN1 ist beispielsweise mit einer Modellkomponenten-Datenbank gekoppelt, die Modellkomponenten MK mit jeweils zugehörigen Modellkomponentenkennungen MKK bereitstellt.

Es werden textbasierte Spezifikationsdaten D_spec für ein technisches System bereitgestellt und dem ersten neuronalen Netz NN1 übergeben. Die textbasierten Spezifikationsdaten D_spec können beispielsweise auf mündlichen Spezifikationsdaten basieren, die über eine Spracheingabeeinheit erfasst werden und als textbasierte Spezifikationsdaten D_spec ausgegeben werden.

Ausgehend von den textbasierten Spezifikationsdaten D_spec generiert das neuronale Netz NN1 aus einer Vielzahl von Modellkomponenten MK ein computerlesbares Modell M. Dabei werden Modellkomponenten MK anhand ihrer Modellkomponentenkennungen MKK in Abhängigkeit der textbasierten Spezifikationsdaten D_spec selektiert und zu einem computerlesbaren Modell M zusammengefügt. Des Weiteren können anhand der textbasierten Spezifikation D_spec Parameterwerte für Parameter des technischen Systems extrahiert und das generierte computerlesbare Modell M in Abhängigkeit der extrahierten Parameterwerte und mittels des ersten neuronalen Netzes parametrisiert werden, d.h. Parameter des Modells M werden eingestellt. Parameter können beispielsweise physikalische Größen sein, die die Modellkomponenten beschreiben.

Das computerlesbare Modell M kann anschließend, beispielsweise zu Planung des technischen Systems, ausgegeben werden. Des Weiteren kann mittels eines Simulationstools ein computergestütztes Simulationsmodell SM auf Basis des computerlesbaren Modells M generiert werden, wenn beispielsweise das computerlesbare Modell M lediglich als formalisiertes Engineering-Modell generiert wird und als ein ausführbares Simulationsmodell umgesetzt werden soll.

Ein Simulationstool kann insbesondere ein Programmierschnittstelle (eng. Application Programming Interface, kurz API) aufweisen. Das Simulationsmodell kann durch die API des Simulationstools generiert werden. Durch die Schnittstelle kann auf das Simulationstool bzw. die internen Funktionen des Tools zugegriffen werden.

Mittels des computergestützten Simulationsmodells kann das technische System und/oder ein Prozess oder eine Funktionalität des technischen Systems simuliert werden. Das computergestützte Simulationsmodell SM kann zum Steuern des technischen Systems ausgegeben werden.

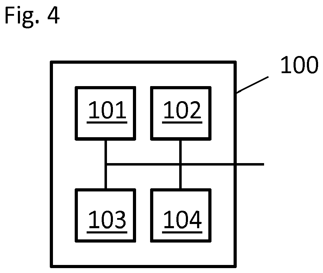

Figur 4 zeigt in schematischer Blockdarstellung eine erfindungsgemäße Vorrichtung 100 zum Generieren eines computerlesbaren Modells für ein technisches System, beispielsweise zur Planung des technischen Systems. Die Vorrichtung 100 umfasst mindestens einen Prozessor 101, der derart eingerichtet ist, die Schritte eines erfindungsgemäßen Verfahrens, wie beispielhaft anhand einer der Figuren 1 bis 3 gezeigt, durchzuführen. Des Weiteren umfasst die Vorrichtung 100 vorzugsweise mindestens eine Speichereinheit 102 oder ist mit einer Speichereinheit oder Datenbank gekoppelt. Auf der Speichereinheit 102 können insbesondere eine Vielzahl von Modellkomponenten gespeichert und bereitgestellt werden. Außerdem kann die Speichereinheit 102 das trainierte erste und/oder zweite neuronale Netz speichern und jeweils als Datenstruktur zur Verwendung bereitstellen. Beispielsweise können die Generative Adversarial Networks in einer Trainingseinheit 103 mittels Trainingsdaten trainiert und an die Speichereinheit 102 bzw. an den Prozessor 101 übermittelt werden. Die Vorrichtung 100 kann außerdem eine Simulationseinheit 104 umfassen oder mit dieser gekoppelt sein, wobei die Simulationseinheit beispielsweise ein Simulationstool in Form von Software aufweist und derart eingerichtet ist, aus Simulationskomponenten ein auf einem Computer ausführbares Simulationsmodell zu erstellen und auszugeben. Des Weiteren kann die Simulationseinheit auch derart eingerichtet sein, das Simulationsmodell auszuführen. Die einzelnen Einheiten der Vorrichtung 100 können sowohl als Software und/oder als Hardware ausgestaltet sein und sind vorzugsweise vorteilhaft miteinander gekoppelt.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Computerimplementiertes Verfahren zum Generieren eines computerlesbaren Modells für ein technisches System, umfassend die Verfahrensschritte:
- Erfassen (S1) von textbasierten Spezifikationsdaten (D_spec) für das technische System, wobei die textbasierten Spezifikationsdaten mindestens eine Systembedingung spezifizieren,
- Bereitstellen (S2) einer Vielzahl von Modellkomponenten (MK) zum computergestützten Modellieren des technischen Systems, wobei einer jeweiligen Modellkomponente (MK) eine Modellkomponentenkennung (MKK) zugeordnet ist,
- Bereitstellen (S3) eines ersten neuronalen Netzes (NN1), das mittels eines zweiten neuronalen Netzes (NN2) darauf trainiert ist, auf Basis textbasierter Spezifikationsdaten für ein technisches System Modellkomponenten anhand deren Modellkomponentenkennungen aus einer Vielzahl von Modellkomponenten zu selektieren und aus den selektierten Modellkomponenten ein computerlesbares Modell für das technische System derart zu generieren, dass Modelldaten (MD) des computerlesbaren Modells mindestens eine in den textbasierten Spezifikationsdaten spezifizierte Systembedingung erfüllen,
- Generieren (S4) eines computerlesbaren Modells (M) für das technische System aus der bereitgestellten Vielzahl von Modellkomponenten (MK) in Abhängigkeit der erfassten textbasierten Spezifikationsdaten (D_spec) mittels des ersten neuronalen Netzes (NN1).

2. Computerimplementiertes Verfahren nach Anspruch 1, wobei anhand der textbasierten Spezifikationsdaten (D_spec) für das technische System Parameterwerte für Parameter des technischen Systems extrahiert und das generierte computerlesbare Modell (M) in Abhängigkeit der extrahierten Parameterwerte und mittels des ersten neuronalen Netzes (NN1) parametrisiert wird.

3. Computerimplementiertes Verfahren nach einem der vorhergehenden Ansprüche, wobei das erste neuronale Netz (NN1) mittels eines zweiten neuronalen Netzes (NN2) und anhand von Trainingsdaten trainiert wird,
- wobei die Trainingsdaten mindestens textbasierte Spezifikationsdaten (D_spec*) eines technischen Systems und/oder Modelldaten (MD*) von mindestens einem computerlesbaren Modell eines technischen Systems umfassen,
- wobei das Training des ersten neuronalen Netzes (NN1) mittels des zweiten neuronalen Netzes (NN2) umfasst, dass mittels des ersten neuronalen Netzes auf Basis textbasierter Spezifikationsdaten für ein technisches System Modellkomponenten anhand deren Modellkomponentenkennungen aus einer Vielzahl von Modellkomponenten selektiert werden, aus den selektierten Modellkomponenten ein computerlesbares Modell für das technische System generiert wird und mittels des zweiten neuronalen Netzes anhand der Trainingsdaten geprüft wird, ob die Modelldaten des vom ersten neuronalen Netz (NN1) generierten computergestützten Modells die in den textbasierten Spezifikationsdaten spezifizierte Systembedingung erfüllen.

4. Computerimplementiertes Verfahren nach einem der vorhergehenden Ansprüche, wobei ein bereitgestelltes computergestütztes Modell für das technische System mittels des zweiten neuronalen Netzes (NN2) validiert wird.

5. Computerimplementiertes Verfahren nach einem der vorhergehenden Ansprüche, wobei Spezifikationsdaten des technischen Systems mittels einer Spracheingabeeinheit erfasst, mittels einer Auswerteeinheit in textbasierte Spezifikationsdaten umgewandelt und die textbasierten Spezifikationsdaten bereitgestellt werden.

6. Computerimplementiertes Verfahren nach einem der vorhergehenden Ansprüche, wobei das computerlesbare Modell (M) als ein computergestütztes Simulationsmodell (SM) zum Simulieren des technischen Systems generiert wird.

7. Computerimplementiertes Verfahren nach Anspruch 6, wobei das technische System und/oder ein Prozess oder eine Funktionalität des technischen Systems mittels des computergestützten Simulationsmodells computergestützt simuliert und/oder das computergestützte Simulationsmodell zum Steuern des technischen Systems ausgegeben wird.

8. Vorrichtung (100) zum Generieren eines computerlesbaren Modells für ein technisches System, wobei die Vorrichtung mindestens einen Prozessor zum Durchführen der Schritte eines Verfahrens nach den vorhergehenden Ansprüchen aufweist.

9. Computerprogrammprodukt eingerichtet zum Ausführen eines computergestützten Verfahrens nach einem der Ansprüche 1 bis 7.

10. Computerlesbares Speichermedium mit einem Computerprogrammprodukt nach Anspruch 9.
